# EUROPEAN PATENT APPLICATION

(11) **EP 4 543 155 A1**
(43) Date of publication of application: **23.04.2025**
(21) Application number: 23842390.9
(22) Date of filing: 20.07.2023
(51) Int. Cl.: H05K 7/20

(54) **SERVER AND SERVER SYSTEM**

(30) Priority: 20.07.2022 CN 202210854317
(71) Applicant: xFusion Digital Technologies Co., Ltd., Zhengzhou, Henan 450000 (CN)
(72) Inventor: JIA, Hui, Zhengzhou, Henan 450000 (CN); WANG, Guangjing, Zhengzhou, Henan 450000 (CN)
(74) Representative: MERH-IP Matias Erny Reichl Hoffmann Patentanwälte PartG mbB
(86) International application number: PCT/CN2023/108363
(87) International publication number: WO 2024/017328

(57) **Abstract**

A server and a server system are provided. The server system includes a server and a cooling medium distributing device. The server includes a first electronic node, a second electronic node, and a cooling connection device. The first electronic node and the second electronic node are connected with the cooling medium distributing device through the cooling connection device. The cooling medium distributing device conveys a liquid cooling medium of the same working medium to the first electronic node and the second electronic node, so that the first electronic component of the first electronic node can dissipate heat in a two-phase heat dissipation mode, and the second electronic component of the second electronic node can dissipate heat in a single-phase liquid cooling manner. The server provides two heat dissipation modes and implements full liquid cooling to meet different heat dissipation requirements of each server and improve the heat dissipation performance of the server.

## Description

This application claims priority to Chinese Patent Application No. 202210854317.6, filed with the China National Intellectual Property Administration on July 20, 2022 and entitled "SERVER AND SERVER SYSTEM", which is incorporated herein by reference in its entirety.

### TECHNICAL FIELD

The application relates to the field of server technologies, and in particular to a server and a server system.

### BACKGROUND

Such as internet service providers, enterprise platforms, research institutes, etc., all require a large amount of computing requirements. A data center is an operation platform that meets storage, compute, and network requirements. With the increasing demand for information and communication technology in modern society, data centers are developing rapidly. As a result, information and communication technology (Information and Communication Technology, ICT) equipment in data centers is gradually developing from low density to high density. High-density ICT equipment generate significant heat during operation. Therefore, A cooling system is required to ensure proper operation of ICT equipment in the data center.

A server system in the related technologies includes a radiator box for accommodating a liquid cooling medium, and heating components such as compute nodes, switches, battery assemblies, and power assemblies immersed in the cooling medium. Wherein, after the cooling medium absorbs the heat generated by the heating components, the temperature rises and the liquid cooling medium enters a heat exchange device through a pipe to reduce the temperature of the liquid cooling medium, so as to perform single-phase liquid cooling heat dissipation on the heating components. But for some heating components, the liquid cooling heat dissipation mode cannot meet the usage requirement.

Therefore, how to improve the heat dissipation performance of servers becomes an urgent problem.

### SUMMARY

Embodiments of this application provide a server and a server system. The heat dissipation mechanism of the server can perform full liquid cooling for an electronic node of the server to improve the heat dissipation performance of services.

According to a first aspect, an embodiment of the present application provides a server. The server includes at least: a cabinet body, a first electronic node, a second electronic node, and a cooling connection device. The cabinet body includes an accommodating cavity for accommodating the first electronic node and the second electronic node. The cooling connection device includes a first pipe, a second pipe, and a third pipe. The first electronic node includes at least one first electronic component and a housing. The housing has a cavity for accommodating the first electronic component, and the housing has a first liquid inlet and an air outlet connected with the cavity. Wherein, the first liquid inlet is connected with the first pipe, and the air outlet is connected with the second pipe; after the liquid cooling medium enters the housing through the first pipe, and absorbs the heat of the first electronic component, the liquid cooling medium becomes a gaseous cooling medium, the gaseous cooling medium flows out of the housing through the second pipe. The second electronic node includes at least one second electronic component and at least one liquid cooling heat dissipation device, the liquid cooling heat dissipation device has a second liquid inlet and a liquid outlet. Wherein, the second liquid inlet is connected with the first pipe, and the liquid outlet is connected with the third pipe; the liquid cooling medium enters the liquid cooling heat dissipation device through the first pipe, after absorbing the heat of the second electronic component, the liquid cooling medium flows out of the liquid cooling heat dissipation device through the third pipe.

The server in an embodiment of the present application is used for cooperating with a cooling medium distributing device. When the server works, the cooling medium distributing device conveys the liquid cooling medium of the same working medium through the first pipe respectively to the first electronic node and the second electronic node. The liquid cooling medium in the first electronic node performs two-phase heat dissipation for the first electronic component, to reduce the temperature of the first electronic component. Simultaneously, the liquid cooling medium in the second electronic node performs single-phase liquid cooling heat dissipation for the second electronic component, to reduce the temperature of the second electronic component. The gaseous cooling medium generated in the first electronic node can enter the cooling medium distributing device through the second pipe and is condensed into the liquid cooling medium by the cooling medium distributing device. The liquid cooling medium in the second electronic node can enter the cooling medium distributing device through the third pipe and is cooled by the cooling medium distributing device. Therefore, the first electronic component may adopt a two-phase heat dissipation mode, and the second electronic component may adopt a single-phase liquid cooling heat dissipation mode. Two heat dissipation modes are provided for each electronic node of the server to meet different heat dissipation requirements of each electronic node of the server, and help improve the heat dissipation performance of the server.

In one possible embodiment, the first electronic node is a compute node, that the compute node is used to perform computing functions, the first electronic component includes a processor and a storage device.

In one possible embodiment, the first electronic component is immersed in the liquid cooling medium within the cavity, so arranged that two-phase heat dissipation of the first electronic component can be achieved and the amount of used cooling medium can be reduced while the heat dissipation requirement of the first electronic component is met.

In one possible embodiment, the housing contains at least one sprinkler. The sprinkler is connected to the first liquid inlet, the sprinkler is positioned above the liquid level of the cooling medium, the sprinkler is used to spray the cooling medium to the first electronic component. Because the sprinkler is located above the liquid level of the liquid cooling medium, the amount of the cooling medium can be reduced, thereby reducing the cooling cost of the compute node. In addition, the sprinkler can improve the heat dissipation capability of the first electronic component to meet a high heat generation scenario of the compute node.

In one possible embodiment, the number of the second electronic nodes is at least one. At least one of the second electronic nodes includes at least one of the following electronic nodes: a switching node, a power node, or a battery node. In this way, different server requirements can be met.

In one possible embodiment, the second electronic node includes a switching node, the switching node is used for performing network data transmission functions, and the second electronic component includes a switching chip.

In one possible embodiment, the second electronic node includes a power node, the power node is used for performing a power supply function and/or a voltage conversion function, the second electronic component includes a power supply.

In one possible embodiment, at least one second electronic node includes a battery node, the battery node is used for performing a standby power supply function, and the second electronic component includes a battery.

In one possible embodiment, the battery node further includes: a battery frame and the number of the battery is a plurality. A plurality of the batteries are installed in the battery frame and contacted with at least one liquid cooling heat dissipation device arranged on the battery frame. In this way, the heat dissipation requirement of the battery assembly can be met.

In one possible embodiment, the liquid cooling heat dissipation device is a cold plate component, the cold plate component includes at least one cold plate. The cold plate has a seal chamber containing a liquid cooling medium, and the cold plate has a second liquid inlet and a liquid outlet which are connected with the seal chamber.

In one possible embodiment, the cold plate is positioned above the second electronic component, so arranged to help improve the heat dissipation capability of the second electronic component.

In one possible embodiment, the number of cold plates is multiple, the server further including: a fourth pipe and a fifth pipe. The second liquid inlets of all the cold plates are connected with the first pipe through the fourth pipe, the liquid outlets of the cold plates are connected with the third pipe through the fifth pipe. The arrangement can simplify the connection structure of the cold plates with the first pipe and the second pipe.

In one possible embodiment, the sever further including: a quick connector. The second liquid inlet and the liquid outlet of the cold plate are respectively connected with the fourth pipeline and the fifth pipeline through the quick connector. The arrangement is helpful to improving the connection speed of the cold plate with the fourth pipe and the fifth pipe.

In one possible embodiment, the sever further including: a quick connector. The first liquid inlet and the air outlet of the housing are respectively connected with the first pipe and the second pipe through the quick connector. The second liquid inlet and the liquid outlet of the liquid cooling heat dissipation device are respectively connected with the first pipe and the third pipe through the quick connector. The arrangement is helpful to improving the connection speed of each electronic node and the cooling connection device.

In one possible embodiment, the quick connector includes at least one first connector and at least one second connector matched with the first connector. The first connector is used for connecting with the first liquid inlet, the air outlet, the second liquid inlet, or the liquid outlet, the second connector is used for connecting with the first pipe, the second pipe, or the third pipe; or, the first connector is used for connecting with the first pipe, the second pipe, or the third pipe, the second connector is used for connecting with the first liquid inlet, the air outlet, the second liquid inlet, or the liquid outlet. The arrangement can increase the connection speed of each electronic node and the cooling connection device.

In one possible embodiment, the first pipe, the second pipe, and the third pipe are all installed on the rear wall of the cabinet body so that the space behind the cabinet body can be used for installation, and the overall volume of the server can be reduced.

In one possible embodiment, the inner diameter of the first pipe is greater than the inner diameter of the second pipe, and the inner diameter of the second pipe is greater than the inner diameter of the third pipe.

According to a second aspect, an embodiment of the present application provides a server system, including at least: a cooling medium distributing device and one of the servers described in the first aspect. A first input end of the cooling medium distributing device is connected with an air outlet of the server through a second pipe of the server, a second input end of the cooling medium distributing device is connected with a liquid outlet of the server through a third pipe of the server, An output end of the cooling medium distributing device is respectively connected with the first liquid inlet and the second liquid inlet of the server through a first pipe of the server. The cooling medium distributing device is used for conveying the liquid cooling medium of the same working medium to the cavity of the server and a liquid cooling heat dissipation device. The cooling medium distributing device is also used for reducing the temperature of the liquid cooling medium entering the cooling medium distributing device through the third pipe. The cooling medium distributing device is also used for condensing a gaseous cooling medium entering the cooling medium distributing device through the second pipe into a liquid cooling medium.

In one possible embodiment, the cooling medium distributing device includes a condenser, a liquid reservoir, and a transfer pump. An input end of the condenser is connected with the air outlet of the server through the second pipe, an output end of the condenser is connected with a first inlet end of the liquid reservoir. An output end of the liquid reservoir is connected with an input end of the transfer pump, a second inlet end of the liquid reservoir is connected with the liquid outlet of the server through the third pipe. An output end of the transfer pump is respectively connected with the first liquid inlet and the second liquid inlet of the server through the first pipe. The condenser can condense the gaseous cooling medium into the liquid cooling medium to realize the circulation of the cooling medium. The liquid reservoir can temporarily store the liquid cooling medium to avoid excessive liquid cooling medium in the first electronic node and/or second electronic node and to ensure that a total amount of cooling medium in the server is within a predefined range. The transfer pump delivers the liquid cooling medium from the liquid reservoir into each electronic node.

In one possible embodiment, the cooling medium distributing device is installed on a side wall of the server cabinet body, the arrangement helps reduce the placement space required for the server system, so that a larger number of server systems can be installed per unit space.

According to a third aspect, an embodiment of the present application provides a data center. The data center includes at least an equipment room and at least one server system as described in the second aspect configured in the equipment room.

These and other aspects, embodiments and advantages of exemplary embodiments described below will become apparent in conjunction with the accompanying drawings. It should be understood that the specification and drawings are for illustrative purposes only and are not intended to define the limitations of the present application, as described in the attached claims. Other aspects and advantages of the present application will be set forth in the following description, and part of these will be apparent from the description, or learned from the practice of the present application. In addition, aspects and advantages of the present application may be realized and obtained through a mean and a combination specifically indicated in the claims.

### BRIEF DESCRIPTION OF DRAWINGS

FIG. 1 is a stereoscopic structure diagram of a data center according to an embodiment of the present application;
FIG. 2 is an internal structure diagram of a data center according to an embodiment of the present application;
FIG. 3 is a structure diagram of a cabinet body according to an embodiment of the present application;
FIG. 4 is a structure diagram of a server system according to an embodiment of the present application;
FIG. 5 is an internal structure diagram of a compute node according to an embodiment of the present application;
FIG. 6 is an internal structure of a switching node according to an embodiment of the present application;
FIG. 7 is an internal structure of a power node according to an embodiment of the present application;
FIG. 8 is a top view of an internal structure of a power node according to an embodiment of the present application;
FIG. 9 is an internal structure diagram of a battery node according to an embodiment of the present application;
FIG. 10 is a stereoscopic structure diagram of a server according to an embodiment of the present application; and
FIG. 11 is a rear view of a server according to an embodiment of the present application.

### Reference numerals:

10: power node area;
20: battery node area;
30: switching node area;
40: compute node area;
100: server;
11a: first electronic node; 12a: second electronic node;
110: compute node; 111: housing; 112: electronic component to be heat-dissipated; 113: cavity; 114: air outlet; 115: first liquid inlet; 116: cooling medium; 117: sprinkler;
120: power node; 121: power supply frame 122: power supply;
130: battery node; 131: battery frame 132: battery;
140: switching node; 141: switching electronic component;
150: cabinet body; 151: cabinet door 152: cabinet body;
200: server system;
210: cooling medium distributing device; 211: condenser; 212: liquid reservoir; 213: transfer pump; 214: first input end; 215: second input end;
220: liquid cooling heat dissipation device; 221: first cold plate; 222: second cold plate; 223: third cold plate; 224: second liquid inlet; 225: liquid outlet;
230: first pipe; 240: second pipe; 250: third pipe; 260: fourth pipe; 270: fifth pipe;
280: quick connector;
300: equipment room;
400: equipment cabinet;
1000: data center;
X: a length direction; Y: a width direction; Z: a height direction.

### DESCRIPTION OF EMBODIMENTS

The terminology used in the embodiments of the present application is used only for purposes of explanation of specific embodiments of the present application and is not intended to limit the application.

To facilitate understanding, the technical terminology involved in this embodiment of the present application are explained and described.

Full liquid cooling: Full liquid cooling not relying on any fan or chiller, and all heat dissipted by a liquid cooling in a cooling tower.

Cold plate: A heat sink sealed to accommodate liquid flow, which usually attached to a heating element by a thermal interface material to dissipate heat from the heating element.

Two-phase heat dissipation: A heat dissipation mode constructed using the phase change between liquid and gas of the same working medium, which absorbs a large amount of heat during the transition from liquid to gas.

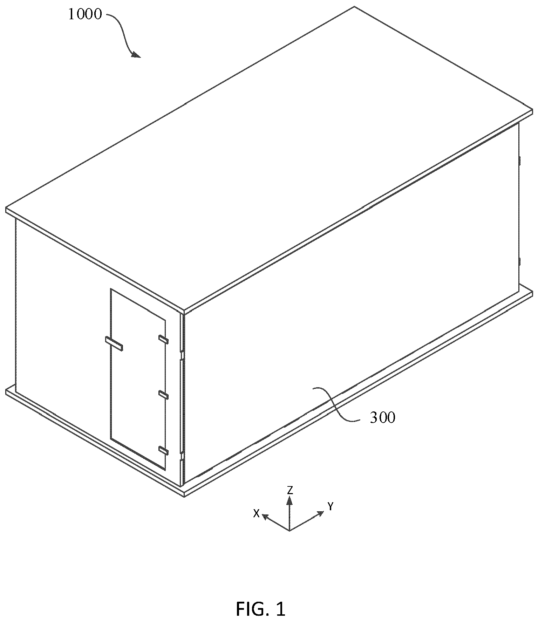

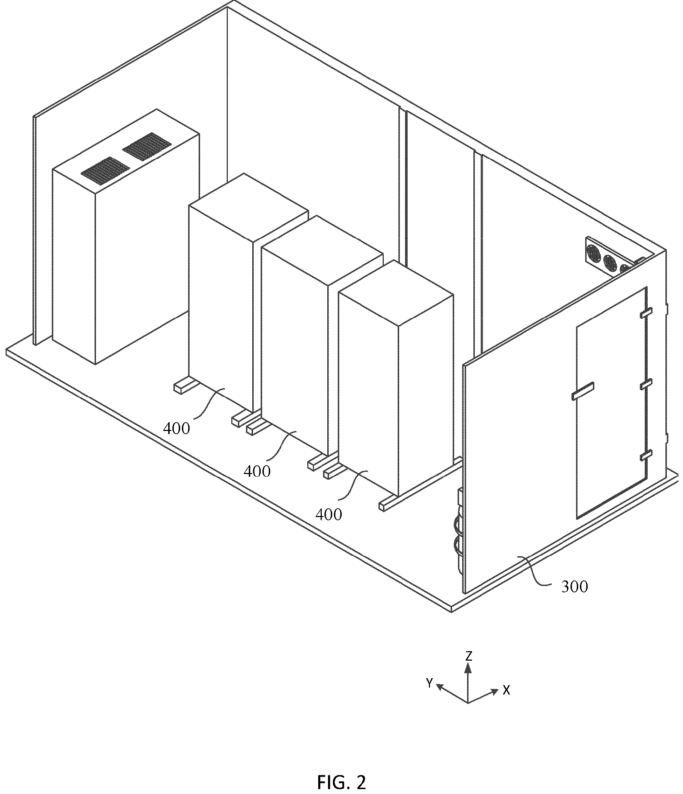

A data center is a globally-collaborated network of a specific device to transfer, accelerate, display, compute, and store data information over an Internet infrastructure. The embodiment of the present application provides a data center. As shown in FIG. 1, the data center may include an equipment room 300. As shown in FIG. 2, the equipment room 300 is provided with at least one equipment cabinet 400. The number of equipment cabinets 400 may include but is not limited to three as shown in FIG. 2. For example, 50-100 equipment cabinets 400 may be included. The equipment room 300 is provided with a cooling system. In this embodiment, a specific structure and a working principle of the cooling system in the equipment room 300 are not described in detail.

Wherein, the equipment cabinet 400 may be a communication cabinet, or, the equipment cabinet 400 may be a power supply 122 cabinet, or, the equipment cabinet 400 may be a server 100 such as a whole cabinet server 100, a rack server 100, etc., the server 100 includes at least one compute node, or the equipment cabinet 400 may be a cooling cabinet that dissipates heat for the server 100. In addition, each server 100 may correspond to one cooling cabinet, or multiple servers 100 may correspond to one cooling cabinet. It should be noted that the cooling cabinet may include a frame body and a heat dissipation device. The frame body is used to carry the heat dissipation device, the heat dissipation device is used to dissipate heat for the server 100. Wherein the frame body may be a cabinet body 150 of the server 100, therefore, the heat dissipation device may be integrated on the server 100.

In a related technology, the heat dissipation device includes a radiator box and a coolant supply device. The radiator box includes a box cover and a box body, the box cover is used for sealing the box body and is connected with the box body in a detachable manner. In addition, heating components of the server, such as compute node, switch, power assembly, battery assembly, etc., are submerged in the liquid cooling medium in the box body. Therefore, the heat dissipation device uses single-phase liquid cooling to dissipate heat from the heating components of the server. However, compute node, switch, power supply assembly, and battery assembly have different heat values, for part of heating components with high heat, the cooling effect of single-phase liquid cooling is poor, affecting the performance of the heating components. In addition, due to the large volume of the box body, when the server needs to be maintained, the box cover needs to be opened by a special equipment to replace or maintain a heating element of the server. For example, when a power supply assembly or a switch needs to be replaced, the box cover needs to be opened by a crane or a mechanical arm before performing maintenance. Therefore, the maintenance is difficult and costly due to the limitation of the heat dissipation device.

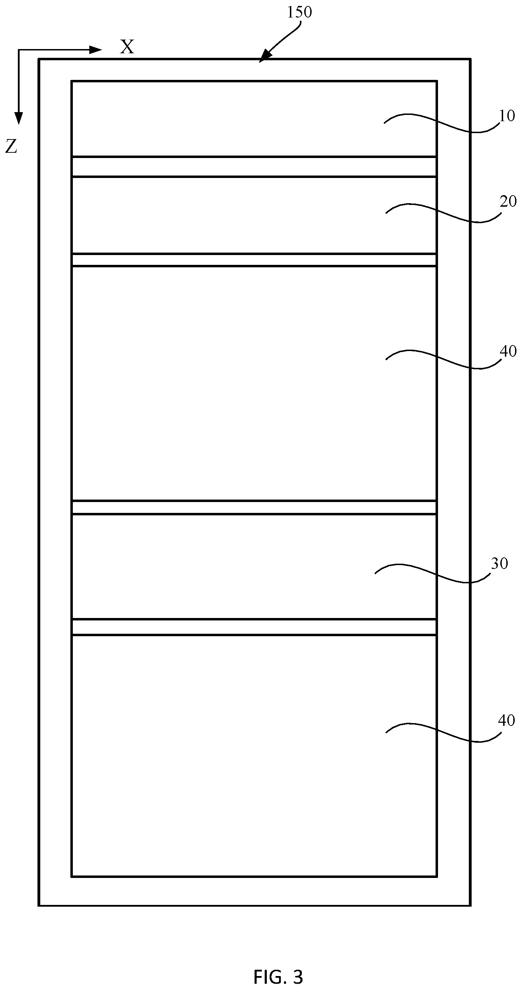

FIG. 3 is a structure diagram of a cabinet according to an embodiment of the present application.

In the embodiment of the present application, as shown in FIG. 3, an inner wall of the cabinet body 150 of the server 100 has an accommodating cavity. The accommodating cavity may be divided into multiple areas according to the different functions of configured nodes. For example, as shown in FIG. 3, the accommodating cavity includes a power node area 10, a battery node area 20, a compute node area 40, and a switching node area 30. The power node area 10 includes at least one power node 120 for performing a power supply function and/or a voltage conversion function. On the one hand, the power of a power grid can supply power for each node of the server 100, and the voltage on the power grid can be converted to the voltage required by each node. The battery node area 20 includes at least one battery node 130 that performs a backup power function, the battery node 130 discharges to provide emergency power to the server 100 when the power grid fails. The switching node area 30 includes at least one switching node 140 for performing network data transmission function. For example, the switching node 140 is electrically connected to multiple compute nodes 110, network data generated by the compute nodes 110 may be aggregated and sent to a terminal connected to the server. The compute node area 40 includes at least one compute node 110 that is used to meet corresponding usage requirements. For example, the compute node may perform computing function. Electronic components with different functions may be provided in different nodes to perform functions of different nodes, for example, electronic components such as a processor and a memory may be provided in the compute node 110 to perform computing functions, the power supply 122 may be provided in the power node 120 to facilitate powering other components in the server 100. The heat dissipation device may be arranged in different nodes to reduce the operating temperature of the electronic components in the node. Further, different heat dissipation devices may be used in different nodes to cool the electronic components in different nodes and improve the heat dissipation efficiency.

In view of this, the present embodiment of the present application provides a server 100, the server 100 includes a cabinet body 150, a first electronic node 11a, a second electronic node 12a, and cooling connections device. The cabinet body 150 includes an accommodating cavity for accommodating multiple nodes, the multiple nodes include the first electronic node 11a and the second electronic node 12a, different nodes may be located in different areas. The cooling connection device includes a first pipe 230, a second pipe 240, and a third pipe 250. Wherein, the first electronic node 11a includes at least one first electronic component and a housing 111, the housing 111 has a cavity 113 for accommodating the first electronic component. The housing 111 has a first liquid inlet 115 and an air outlet 114. The first liquid inlet 115 is connected with the first pipe 230, liquid cooling medium 116 may be input to the two-phase heat dissipation device through the first pipe 230, the air outlet 114 is connected with the second pipe 240, gaseous cooling medium 116 can be output through the second pipe 240. The second electronic node 12a includes at least one second electronic component and at least one liquid cooling heat dissipation device 220, the liquid cooling heat dissipation device 220 has a second liquid inlet 224 and a liquid outlet 225. The second liquid inlet 224 is connected with the first pipe 230, and a liquid cooling medium 116 can be input into the liquid heat dissipation device 220 through the first pipe 230. The liquid outlet 225 is connected with the third pipe 250, the liquid cooling medium 116 can be output through the third pipe 250. In this way, the first electronic component can be dissipated in a two-phase heat dissipation mode, and the second electronic component can be dissipated in a single-phase liquid cooling mode, and the cooling connection device can provide the same liquid cooling medium 116 for each area of the server 100, and the server 100 can provide two heat dissipation modes to meet the different cooling requirements of the various areas of the server 100, helping to improve the heat dissipation performance of the server 100.

It should be noted that the electronic node is a switching node 140, a battery node 130, a power node 120, a compute node 110, or other nodes in the server 100. In addition, the node types of the first electronic node 11a and the second electronic node 12a may be the same or different, and be not specifically limited herein. For example, in the embodiment of the present application, the types of the first electronic node 11a and the second electronic node 12a are different. Specifically, the first electronic node 11a may be the compute node 110, and the second electronic node 12a may be any of the following electronic nodes: the switching node 140, the battery node 130, and the power node 120. Alternatively, the quantity of the second electronic nodes 12a is multiple, and the second electronic nodes 12a can be at least one of the following: the switching node 140, the battery node 130, and the power node 120. For example, part of the second electronic nodes 12a are the switching nodes 140, and part of the second electronic nodes 12a are the battery nodes 130.

With reference to specific embodiments, an embodiment of the present application provides a server system 200 in detail below.

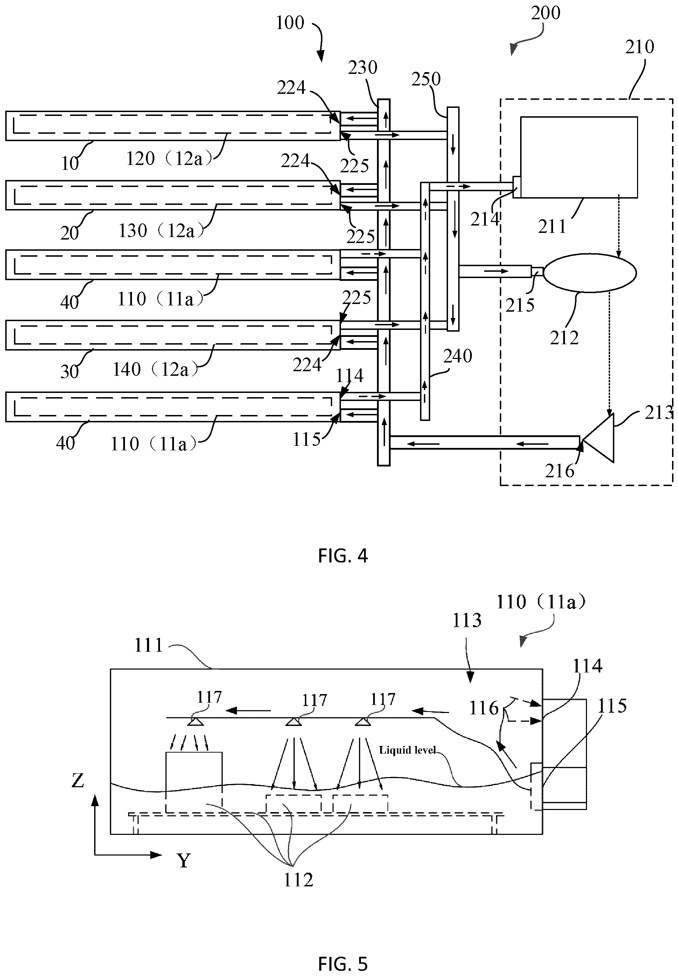

FIG. 4 is a structure diagram of a server system according to an embodiment of the present application.

An embodiment of the present application provides a server system 200. Referring to FIG. 4, the server system 200 may include a cooling medium distributing device 210 and a server 100. The server 100 includes a first pipe 230, a second pipe 240, a third pipe 250, a power node area 10, a battery node area 20, a switching node area 30, and a compute node area 40. The number of the respective areas may depend on the quantity and location of the nodes, and is not specifically limited herein. For example, in the embodiment of the application, the number of the compute node areas 40 is two, and the two compute node areas 40 may be located closely or separately. The number of nodes in each area may also be determined according to the actual situation. There is no specific restriction here. In FIG. 4, for example, each area includes only one node, for example, the power node area 10 includes a power node 120, the battery node area 20 includes a battery node 130, the compute node area 40 includes a compute node 110, and the switching node area 30 includes a switching node 140.

One cooling medium distributing device 210 may correspond to one server 100, or one cooling medium distributing device 210 may correspond to multiple servers 100. The cooling medium distributing device 210 may be integrally disposed with the server 100. For example, the cooling medium distributing device 210 may be mounted on the side wall of the cabinet body 150 of the server 100, or the cooling medium distributing device 210 may be set separately from the server 100.

In particular, on the one hand, the output of the cooling medium distributing device 210 may be connected with the power node 120, the battery node 130, the second inlet 224 of the switching node 140, and the first inlet 115 of the compute node 110 through the first pipe 230. The air outlet 114 of the compute node 110 is connected with a first input end 214 of the cooling medium distributing device 210 through the second pipe 240, so that the cooling medium distributing device 210 can deliver the liquid cooling medium 116 of the same working medium to the nodes of the multiple areas. On the other hand, the liquid outlet 225 of the power node 120, the battery node 130, and the switching node 140 is connected with a second input end 215 of the cooling medium distribution device 210 through the third pipe 250, to perform single-phase liquid cooling heat dissipation for the power node 120, the battery node 130, and the switching node 140, and perform two-phase heat dissipation for the compute node 110.

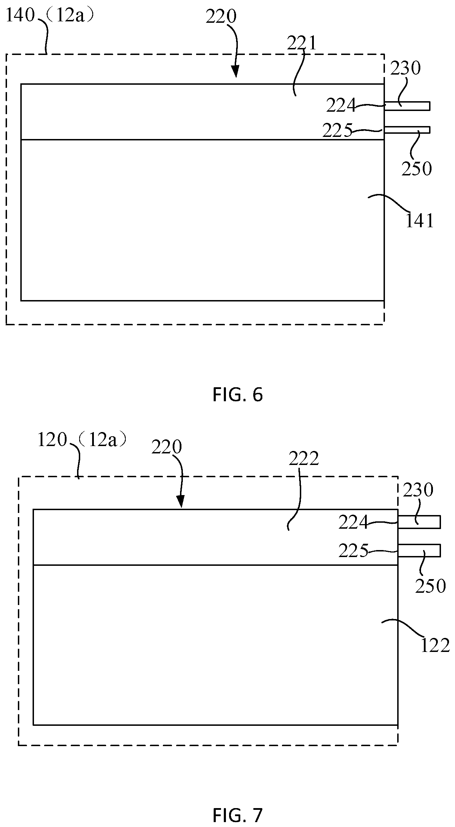

It should be noted that the power node 120, the battery node 130, and the switching node 140 may adopt a single-phase liquid cooling heat dissipation mode. For details, see FIG. 6 to FIG. 9. At least one liquid cooling heat dissipation device 220 may be provided in the power node 120, the battery node 130, and the switching node 140. The second liquid inlets 224 are respectively provided on the liquid cooling heat dissipation devices 220 of different nodes. The first pipe 230 is connected with the second liquid inlets 224 in the nodes. In fact, the first pipe 230 is connected with the second liquid inlet 224 of the liquid cooling heat dissipation device 220 in the node, so that the cooling medium distribution device 210 inputs the liquid cooling medium 116 into the liquid cooling heat dissipation device 220 of the power node 120, the battery node 130, and the switching node 140, respectively to dissipate heat for electronic components. Similarly, the liquid outlets 225 are also respectively provided in the liquid cooling heat dissipation devices 220 of different nodes and connected with the third pipe 250, so that the liquid cooling heat dissipation device 220 of the power node 120, the battery node 130, and the switching node 140 respectively output the liquid cooling medium 116 to the cooling medium distributing device 210. A two-phase heat dissipation mode may be used in the compute node 110, as shown in Figure 4. The detailed arrangement is shown in Figure 5. The compute node 110 is provided with a housing 111, the electronic components to be heat dissipated of the compute node 110 are positioned in the housing 111, and the first liquid inlet 115 is positioned in the housing 111 and is connected with the first pipe 230 so that the cooling medium distribution device 210 inputs the liquid cooling medium 116 into the housing 111 of the compute node 110. Similarly, the air outlet 114 is also provided on the housing 111 and is connected with the second pipe 240, so that the compute node 110 outputs the gaseous cooling medium 116 to the cooling medium distributing device 210.

It is understandable that multiple first liquid inlets 115 may be provided in the housing 111 of the compute node 110, multiple first liquid inlets 115 may be connected with a first pipe 230, or the server 100 may further include multiple first pipes 230. Multiple first pipes 230 may be connected with the first liquid inlet 115 through a quick connector 280, or multiple first liquid inlets 115 and multiple first pipes 230 may be connected via the quick connector 280. That is to say, the corresponding relationship between the first liquid inlet 115 and the first pipe 230 may be set according to actual conditions, and is not limited in this application. Similarly, the corresponding relationship between the second liquid inlet 224 and the first pipe 230, the liquid outlet 225 and the third pipe 250, and the air outlet 114 and the second pipe 240 may also be set according to actual conditions, and is not limited herein. Similarly, in order to increase the speed of connection between the liquid cooling heat dissipation device 220 and the first pipe 230 and the third pipe 250, the second inlet 224 and outlet 225 of the liquid cooling heat dissipation device 220 may be respectively connected with the first pipe 230 and the third pipe 250 through the quick connector 280.

The cooling medium 116 may be a low boiling and non-conductive liquid, for example, the cooling medium 116 may be a fluorinated liquid, and the normal boiling point of the cooling medium 116 may be from 30°C to 60°C, although the specific type of cooling medium 116 is not specifically limited herein.

Specifically, the cooling medium distributing device 210 may include a condenser 211, a liquid reservoir 212, and a transfer pump 213. An input end of the condenser 211 is connected with the gas outlet 114 of the compute node 110 through the second pipe 240, and an output end of the condenser 211 is connected with a first inlet end of the liquid reservoir 212. The condenser 211 is used for condensing the vaporized cooling medium 116 into the liquid cooling medium 116. The first input end 214 of the cooling medium distributing device 210 is the input end of the condenser 211.

An output end of the liquid reservoir 212 is used for connecting with an input end of the transfer pump 213, and a second inlet end of the liquid reservoir 212 is respectively connected with the liquid outlet 225 of the power node 120, the battery node 130, and the switching node 140 through the third pipe 250. The liquid reservoir 212 is used to temporarily store the liquid cooling medium 116. Wherein the second input end 215 of the cooling medium distributing device 210 is the second inlet end of the liquid reservoir 212.

An output end of the transfer pump 213 is respectively connected with the power node 120, the battery node 130, the first liquid inlet 115 of the switching node 140, and the second liquid inlet 224 of the compute node 110 through the first pipe 230 to deliver the liquid cooling medium 116 of the same working medium to each area. An output end of the cooling medium distributing device 210 is the output end of the transfer pump 213.

Thus, referring to FIG. 4, during heat dissipation, the transfer pump 213 delivers the liquid cooling medium 116 along the first pipe 230 into the power node 120, the battery node 130, the switching node 140, and the compute node 110. The liquid cooling medium 116 entering the compute node absorbs heat and is vaporized. The gaseous cooling medium 116 enters the condenser 211 along the second pipe 240. The condenser 211 condenses the gaseous cooling medium 116 into the liquid cooling medium 116 and enters the liquid reservoir 212. The liquid cooling medium 116 entering the power node 120, battery node 130, and exchange node 140 absorbs heat and enters the liquid reservoir 212 along the third pipe 250 to carry away the heat generated by the electronic components within these nodes.

In the server system 200 according to the embodiment of the present application, the server system 200 uses the liquid cooling medium 116 of the same working medium to perform full liquid cooling on the server 100, which simplifies the structure of the server 100 and helps reduce the cost, in addition, in the mode of full liquid cooling, components such as the server 100 fan, an air conditioner in the equipment room 300, and a water chiller in the equipment room 300 can be removed, which helps to improve the energy efficiency of the server system 200. In addition to that, the two-phase heat dissipation and the single-phase liquid cooling can coexist, which meets the heat dissipation requirements of different heating components and helps to improve the heat dissipation performance of the server 100.

It should be noted that the server 100 in FIG. 4 includes the power node area 10, the battery node area 20, the switching node area 30, and the compute node area 40 as an example only. The server 100 may include only portions of the power node area 10, the battery node area 20, the switching node area 30, and the compute node area 40, or may include other areas. In FIG. 4, for example, the nodes in the power node area 10, the battery node area 20, and the switching node area 30 use the liquid cooling mode to dissipate heat, and the compute node 110 uses the two-phase cooling mode to dissipate heat. In practice, different heat dissipation modes may be adopted according to the heat dissipation requirements of the electronic components in the node. For example, the nodes in the power node area 10 and the battery node area 20 use liquid cooling for heat dissipation, and the nodes in the switching node area 30 and the compute node area 40 use two-phase heat dissipation. Further, different nodes in the same area may also use different heat dissipation devices to dissipate heat.

The following example describes the structure of the nodes in the power node area 10, the battery node area 20, and the switching node area 30. The nodes in the power node area 10, battery node area 20, and switching node area 30 adopt liquid cooling and compute node 110 adopts two-phase heat dissipation mode.

Firstly, a specific structure of the compute node 110 is described in the following example: the compute node area 40 includes a compute node 110. The compute node 110 may use the two-phase heat dissipation mode to dissipate heat for the electronic components 112 to be heat-dissipated in the compute node 110. It is understood that, since the electronic component 112 to be heat-dissipated uses the two-phase heat dissipation mode to dissipate heat, the electronic component 112 to be heat-dissipated is the first electronic component of the first electronic node 11a in the embodiment of the present application. Figure 5 shows the internal structure diagram of a compute node provided in an embodiment of the present application. Figure 5 shows the following:

The compute node 110 includes a housing 111 and an electronic component 112 to be heat-dissipated, the housing 111 has a cavity 113, an air outlet 114 and a first liquid inlet 115 connected with the cavity 113, the electronic component 112 to be heat-dissipated in the cavity 113. The air outlet 114 is connected with the first input end 214 of the cooling medium distributing device 210 through the second pipe 240, and the first inlet 115 is connected with the output end of the cooling medium distributing device 210 through the first pipe 230. In addition, the electronic component 112 to be heat-dissipated is positioned within the cavity 113 and immersed in the liquid cooling medium 116 within the cavity 113. During the heat dissipation, the heat generated by the electronic component 112 to be heat-dissipated is absorbed by the liquid cooling medium 116 so that the liquid cooling medium 116 becomes the gaseous cooling medium 116, and then the vaporized cooling medium 116 enters the cooling medium distributing device 210 through the air outlet 114. The cooling medium distributing device 210 then condenses the vaporized cooling medium 116 into the liquid cooling medium 116.

The electronic component to be heat-dissipated is immersed into the liquid cooling medium 116. It is understandable that along the height and direction of the compute node 110 (direction Z in FIG. 5), a portion of the electronic component 112 to be heat-dissipated is submerged in the cooling medium 116, and a portion of the to-be-dissipated electronic component 112 is located above the liquid level of the cooling medium 116, or the electronic component 112 to be heat-dissipated is completely submerged in the cooling medium 116.

When the portion of the electronic component 112 to be heat-dissipated is immersed in the cooling medium 116 and the other portion of the electronic component 112 to be heat-dissipated is located above the liquid level of the cooling medium 116, the amount of the cooling medium 116 used for dissipating the heat of the electronic component 112 to be heat-dissipated can be reduced to decrease the cooling cost.

It should be noted that the electronic component 112 to be heat-dissipated is a general terminology for all heating devices, which may be a circuit board, a resistor, a CPU, a graphics processor, a heat sink, a capacitor, a power supply 122, a memory, and a storage device, etc. In addition, the number of each type of heating device may be one or more, and is not specifically limited herein.

In the embodiment of the present application, referring to FIG. 5, the compute node 110 may further include at least one sprinkler 117, each cavity 113 is provided with at least one sprinkler 117. The sprinkler 117 may be used to spray the liquid cooling medium 116 toward the electronic component 112 to be heat-dissipated to improve the heat dissipation capability of the compute node 110. The sprinkler 117 may be connected with the outlet end of the cooling medium distributing device 210 through the outlet 114 so that the cooling medium distributing device 210 can deliver the liquid cooling medium 116 to the sprinkler 117.

The sprinkler 117 may spray the liquid cooling medium 116 toward the electronic components 112 to be heat-dissipated below the liquid level of the cooling medium 116, or the sprinkler 117 may spray the liquid cooling medium 116 toward the electronic components 112 to be heat-dissipated above the liquid level of the cooling medium 116, or the number of sprinklers 117 is multiple, and the sprinkler 117 can simultaneously spray the liquid cooling medium 116 to the electronic components 112 to be heat-dissipated below and above the liquid level.

When the liquid cooling medium 116 sprayed by the sprinkler 117 directly hits the surface of the electronic component 112 to be heat-dissipated, the single-point heat dissipation capability of the electronic component 112 to be heat-dissipated is increased. In addition, the speed at which the gaseous cooling medium 116 vaporized from the liquid cooling medium 116 is increased. The single-point heat dissipation capability refers to the heat dissipation capability of the area where the electronic component 112 to be heat-dissipated cooperates with the sprinkler 117. Specifically, it refers to the heat dissipation capability of the heating components at different positions in the electronic component 112 to be heat dissipated.

Since the sprinkler 117 can continuously spray the liquid cooling medium 116 toward the electronic component 112 to be heat-dissipated, or the sprinkler 117 can spray the liquid cooling medium 116 toward the electronic component 112 to be heat-dissipated at a predetermined interval. The cooling medium 116 impacts on the surface of the electronic component 112 to be heat-dissipated. On the one hand, the gaseous cooling medium 116 formed in the vicinity of the collision point can be rapidly separated from the liquid cooling medium 116, so that the gaseous cooling medium 116 enters the cooling medium distributing device 210 through the air outlet 114 to avoid a high ambient temperature in the vicinity of the collision point, the high temperature results in a lower phase change rate of the liquid cooling medium 116. On the other hand, the jet of cooling medium 116 may increase the replenishment rate of the liquid cooling medium 116 in the vicinity of the collision point to increase the replacement rate of the liquid cooling medium 116, thereby increasing the single-point heat dissipation capability of the electronic component 112 to be heat-dissipated.

Therefore, the compute node 110 adopts the two-phase heat dissipation mode, so that the electronic component 112 to be heat-dissipated with large heat output can be directly immersed in the cooling medium 116, and the cooling medium 116 is used to vaporize and absorb heat to take away most of the heat of the electronic component 112 to be heat-dissipated, thereby improving the heat dissipation efficiency.

Hereinafter, take the switching node area 30 as an example. The switching node area 30 includes a switching node 140. The specific structure of the switching node 140 is described as follows. The switching node 140 may use the liquid cooling mode to dissipate heat for a switching electronic component 141 in the switching node 140. Figure 6 shows the internal structure diagram of a switching node provided in an embodiment of the present application.

The switching node 140 may include a liquid cooling heat dissipation device 220 and a switching electronic component 141 to be heat dissipated. The liquid cooling heat dissipation device 220 may specifically include a cold plate component for performing single-phase liquid cooling heat dissipation for the switching node 140. Specifically, the cold plate component may include multiple first cold plates 221 that are in contact with a heating device of the switching electronic component 141, and the heating device is heat-exchanged with the liquid cooling medium 116 in the first cold plate 221 to remove heat from the switching electronic component 141. For example, in the embodiment of the present application, the first cold plate 221 is positioned above the switching electronic component 141 and is in contact with the top surface of all the heating devices of the switching node 140, which improves the heat dissipation speed of the switching electronic component 141.

The first cold plate 221 has a liquid outlet 225 and a first liquid inlet 115, the second liquid inlet 224 of the first cold plate 221 is connected with the output end of the cooling medium distributing device 210 through the first pipe 230. The liquid outlet 225 of the first cold plate 221 connects with the second input end 215 of the cooling medium distributing device 210 through the third pipe 250. In addition, each switching electronic component 141 may correspond to at least one first cold plate 221, which is not specifically limited herein. For example, in the embodiment of the present application, each switching electronic component 141 corresponds to a first cold plate 221 that is in contact with all the heating devices of each switching electronic component 141.

The first cold plate 221 may be fastened to the switching electronic component 141, for example, The first cold plate 221 is fastened to the switching electronic component 141 by means of a snapping connection or a threaded connection. Of course, the first cold plate 221 may also be mounted on the cabinet body 150 of the server 100.

It is understandable that since the switching electronic component 141 performs the single-phase liquid cooling heat dissipation by the liquid cooling heat dissipation device 220. Therefore, the switching node 140 is equivalent to the second electronic node 12a, the switching electronic component 141 is equivalent to the second electronic component. And the switching electronic component 141 may include a switching chip. The switching node 140 may thus provide high performance and low latency switching.

Hereinafter, take the power node 10 as an example. The power node 10 includes a power node 120 and the specific structure of the power node 120 described below. The power node 120 may dissipate heat for a power electronic component in the power node 120 by using the liquid cooling mode. The power electronic component may include a power supply 122. Figure 7 shows the internal structure diagram of a power node provided in an embodiment of the present application, as shown in Figure 7.

The power node 120 may include a liquid cooling heat dissipation device 220 and a power supply 122 to be heat dissipated. The liquid cooling heat dissipation device 220 may specifically include a cold plate component for performing the single-phase liquid cooling heat dissipation for the power node 120. In particular, the cold plate component may include multiple second cold plates 222, similar to the first cold plate 221, which may be used for heat exchange with the power supply 122 within the power node 120. The second cold plate 222 is in contact with a heating device within the power supply 122. Thus, the liquid cooling medium 116 in the second cold plate 222 exchanges heat with the heating device. The liquid cooling medium 116 in the second cold plate 222 dissipates the heat generated by the power supply 122, thereby reducing the temperature of the power node 120.

The second cold plate 222 has a first liquid inlet 115 and a liquid outlet 225, a second liquid inlet 224 of the second cold plate 222 is connected with the output end of the cooling medium distributing device 210 through the first pipe 230. The liquid outlet 225 of the second cold plate 222 is connected with the second input end 215 of the cooling medium distributing device 210 through the third pipe 250, so that the liquid cooling medium 116 can circulate between the second cold plate 222 and the cooling medium distributing device 210 to maintain the temperature of the power node 120 within a predetermined range.

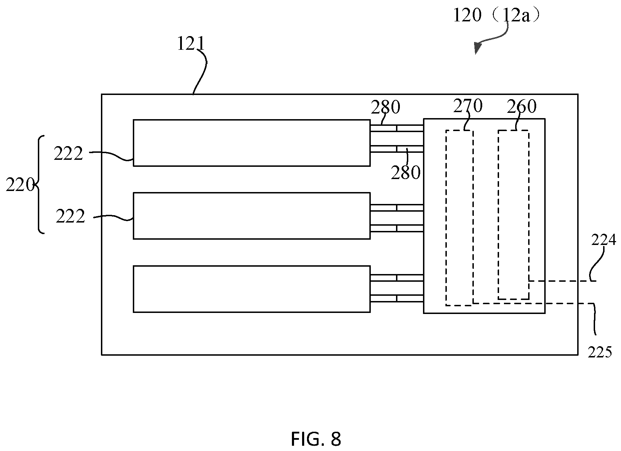

The power node 120 may include at least one second cold plate 222, the number of the second cold plates 222 may depend on the number of power supplies 122, but is not specifically limited herein. FIG. 8 is a top view of an internal structure of a power node according to an embodiment of the present application. Referring to FIG. 8, the power node 120 further includes a power supply frame 121, which includes three power supplies 122. Correspondingly, the number of second cold plate 222 is 3, and each power supply 122 corresponds to one second cold plate 222, as shown in FIG. 7. Each second cold plate 222 is in contact with all the heating devices of the power source 122 corresponding to the second cold plate 222. Since the second cold plate 222 is located above the power supply 122 when viewed from above, the power supply 122 is blocked by the second cold plate 222 in FIG. 1 and the power supply 122 is not identified.

Optionally, when the number of the second cold plates 222 is multiple, referring to FIG. 8, the server 100 further includes a fourth pipe 260 and a fifth pipe 270. All the second liquid inlets 224 of the second cold plate 222 are connected with the first pipe 230 through the fourth pipe 260. Thereby, the cooling medium distributing device 210 delivers the liquid cooling medium 116 to all the second cold plates 222. The liquid outlet 225 of all the second cold plates 222 are connected with the third pipe 250 through the fifth pipe 270. Thus, all of the liquid cooling medium 116 in the second cold plate 222 may enter the cooling medium distributing device 210.

In order to increase the speed of connection of the second cold plate 222 to the fourth pipe 260 and the fifth pipe 270, referring to FIG. 7 and FIG. 8, the server 100 further includes a quick connector 280. Both the first inlet 115 and the outlet 225 of the second cold plate 222 may be connected with the fourth pipe 260 and the fifth pipe 270 through the quick connector 280. For example, the quick connector 280 includes a first connector and a second connector, the first connector is connected with the outlet 225 or the first inlet 115 of the second cold plate 222, the second connector is connected with the fourth pipe 260 or the fifth pipe 270.

Optionally, referring to FIG. 8, multiple power supplies 122 are connected to the power supply frame 121 in a detachable manner, and each power supply 122 corresponds to a second cold plate 222, and the second cold plate 222 is in contact with all heating devices of the power supply 122.

In addition, the fourth pipe 260 and the fifth pipe 270 may also be mounted on the power supply frame 121 to improve the compactness of the power node 120.

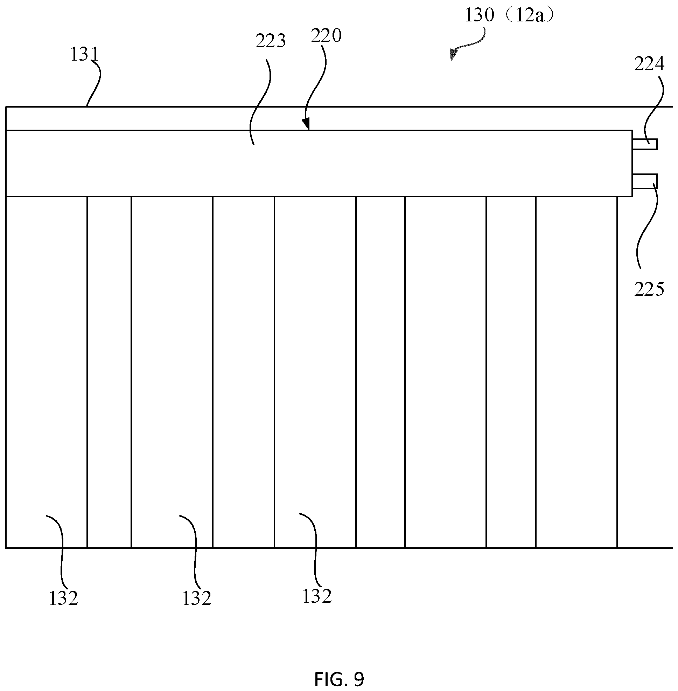

Hereinafter, take the battery node area 20 as an example. The battery node area 20 includes a battery node 130 and the specific structure of the battery node 130 described below. The battery node 130 may dissipate heat for a battery electronic component in the battery node 130 by using the liquid cooling mode. The battery electronic component includes a battery 132. FIG. 9 shows the internal structure of a battery node provided in an embodiment of the present application.

The battery node 130 may include a liquid cooling heat dissipation device 220 and a battery 132 to be heat dissipated. The liquid cooling heat dissipation device 220 can specifically include a cold plate component for performing the single-phase liquid cooling heat dissipation for the battery node 130. Specifically, the cold plate component may include multiple third cold plates 223 similar to the first cold plate 221, which may be used for single-phase liquid cooling of the battery 132 in the battery node 130, the liquid cooling medium 116 in the third cold plate 223 exchanges heat with the battery 132, and removes the heat generated by the battery 132, so that the temperature of the battery 132 is maintained within a predetermined range.

The third cold plate 223 has a liquid outlet 225 and a second liquid inlet 224. The second liquid inlet 224 of the third cold plate 223 is connected with the output end of the cooling medium distributing device 210 through the first pipe 230. The liquid outlet 225 of the third cold plate 223 is connected with the second input end 215 of the cooling medium distributing device 210 through the third pipe 250.

The battery node 130 includes at least one third cold plate 223. For example, in this embodiment, the battery node 130 includes a third cold plate 223, the third cold plate 223 is in contact with all heating components of the battery 132.

Referring to FIG. 9, the battery node 130 may include a battery frame 131 and multiple batteries 132. And multiple batteries 132 in the battery frame 131 are in contact with the third cold plate 223 so that the third cold plate 223 exchanges heat with all of the batteries 132.

It should be noted that multiple batteries 132 may correspond to one third cold plate 223 or multiple third cold plates 223. For example, in the embodiment of the present application, as shown in FIG. 9, multiple batteries 132 correspond to one third cold plate 223. The third cold plate 223 is positioned over multiple batteries 132 and in contact with the heating surfaces of all the batteries 132.

It is understandable that since the battery node 130 and the power node 120 are present in the server 100, the data center may not need to configure additional voltage conversion and uninterruptible power supply 122 for standby power, and the server 100 can be flexibly deployed in the data center.

For a node that adopts liquid cooling for heat dissipation, on the one hand, the single-phase liquid cooling for heat dissipation can be performed, one the other hand, the electronic components in the node can be prevented from contacting directly with the liquid cooling medium 116, which helps reduce the maintenance difficulty of the server 100. For example, the maintenance personnel may directly manually plug or unplug power supply 122 within power node 120.

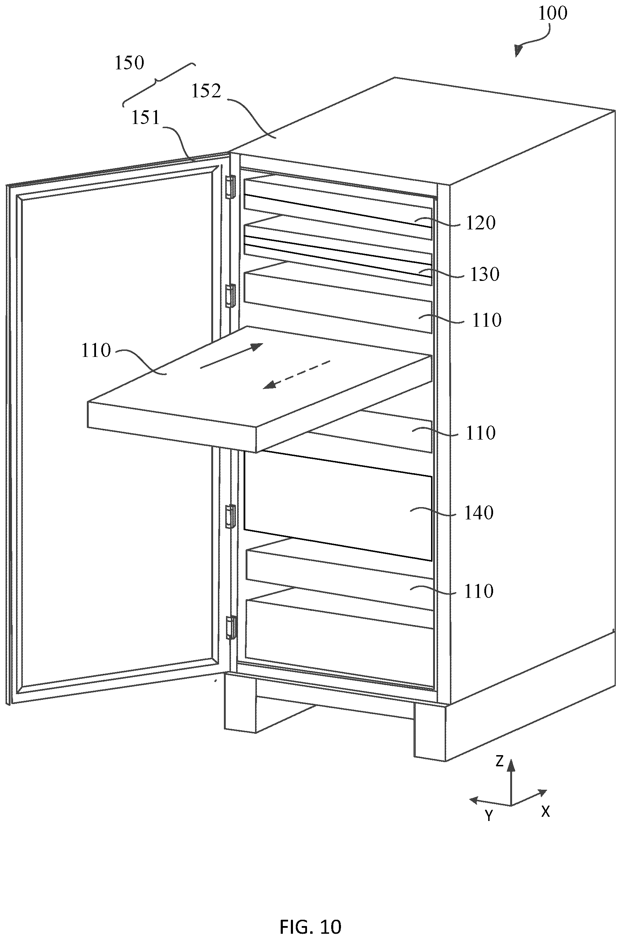

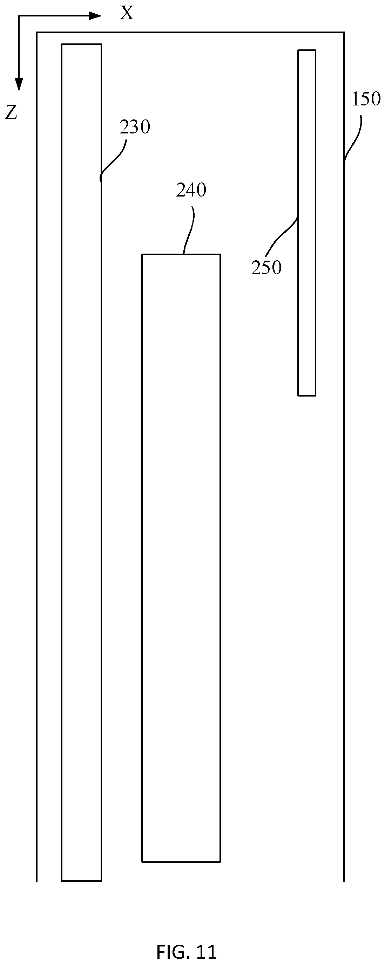

FIG. 10 shows a three-dimensional structure of a server provided in an embodiment of the present application. FIG. 11 shows a rear view of the server provided in an embodiment of the present application.

In some possible implementations, referring to FIG. 10, the server 100 further includes at least one cabinet body 150 with an accommodating cavity for accommodating the compute node 110, the power node 120, the battery node 130, and the switching node 140. In addition, the cabinet body 150 may include a cabinet body 152 and a cabinet door 151, wherein the number of cabinet doors 151 may be one, or the number of cabinet doors 151 may be two, and the two cabinet doors 151 may be arranged opposite each other. For example, one of the cabinet doors 151 may be provided at the front of the cabinet body 150 (for example, as shown in FIG. 10), and the other cabinet door 151 may be provided at the rear of the cabinet body 150. It should be noted that, in some embodiments, the cabinet body 150 may not be provided with the cabinet door 151. For example, the front and rear of the cabinet body 150 can be open, or the front and right sides of the cabinet body 150 may be open.

A bearing structure for bearing the battery node 130, the power node 120, the switching node 140, and the compute node 110 is arranged on the inner wall of the accommodating cavity. For example, multiple bearing plates are arranged on the side wall of the cabinet body 150 at intervals along the height direction of the cabinet body 150, or multiple bearing rings are arranged at intervals on the side walls of the cabinet body 150.

In this embodiment of the present application, the shape and structure of the cabinet body 150 are not specifically limited. In addition, the shape of the cabinet body 150 may vary according to the shape of the compute node 110. For example, the shape of the cabinet body 150 may be a cuboid (see FIG. 10). This reduces the size of a single server system 200 so that multiple server systems 200 can be provided in the equipment room 300. Further, it is understandable that the inner wall of the cabinet body 150 defines a cavity for accommodating multiple compute nodes 110 and the cooling medium distributing device 210, and that a bearing structure (not shown in the figure) for carrying the compute nodes 110 is provided on the cabinet body 150. For example, multiple carrier plates are arranged at intervals on the side walls of the cabinet body 150 in the height direction of the cabinet body 150, or multiple bearer rings are arranged at intervals on the side walls of the cabinet body 150.

It is understandable that at least one power node area 10, at least one battery node area 20, at least one switching node area 30, and at least one compute node area 40 are disposed in the accommodating cavity. For example, as shown in FIG. 3, in the embodiment of the present application, in a height direction of the cabinet body 150, from top to bottom, there is a power node area 10, a battery node area 20, a compute node area 40, a switching node area 30, and a compute node area 40. In addition, the power node area 10 includes at least one power node 120, the battery node area 20 includes at least one battery node 130, the switching node area 30 includes at least one switching node 140, and the compute node area 40 includes at least one compute node 110. For example, in the embodiment of the present application, as shown in FIG. 10, each power node area 10 includes a power node 120, each battery node area 20 includes a battery node 130, each compute node area 40 includes multiple compute nodes 110, and each switching node area 30 includes a switching node 140.

It should be noted that each cooling medium distributing device 210 may correspond to at least one cabinet body 150, for example, each cabinet body 150 may correspond to one cooling medium distributing device 210, or each cooling medium distributing device 210 may correspond to two or three cabinet bodies 150.

In the embodiment of the present application, the cooling connection device includes the first pipe 230, the second pipe 240, and the third pipe 250, all of which may be installed on the cabinet body 150, for example, the first pipe 230, second pipe 240, and third pipe 250 may all be installed on the side wall of the cabinet body 150. The side wall of the cabinet body 150 may be a rear wall, a front wall, a left side wall, or a right-side wall, which is not specifically limited herein. The first pipe 230, the second pipe 240, and the third pipe 250 are located in the rear wall of the cabinet body 150. And it helps reduce the size of the cabinet body 150.

Taking FIG. 10 as an example, in the embodiment of the present application, along the height direction of the cabinet body 150, from top to bottom: there is the power node area 10, the battery node area 20, the switching node area 30 and the compute node area 40. Referring to FIG. 11, the length of the first pipe 230 is greater than the length of the second pipe 240, and the length of the second pipe 240 is greater than the length of the third pipe 250. This can reduce the cost of the pipe.

In some possible implementations, the inside diameters of the first pipe 230, the second pipe 240, and the third pipe 250 may differ from each other. For example, with reference to FIG. 11, the inside diameter of the second pipe 240 is greater than that of the first pipe 230, and the inside diameter of the first pipe 230 is greater than that of the third pipe 250. This arrangement reduces the cost of the first pipe 230, second pipe 240, and third pipe 250.

It is understandable that the inside diameters of the first pipe 230, second pipe 240, and third pipe 250 may also be the same, and are not specifically limited herein.

In some possible implementations, the cooling connection device may further include multiple liquid inlet pipes, multiple air outlet pipes, and multiple liquid outlet pipes (not shown). A portion of the liquid inlet pipe makes the first liquid inlet 115 of the compute node 110 connecting with the first pipe 230, and a portion of the liquid inlet pipe makes the second inlet 224 of the liquid cooling heat dissipation device 220 connecting with the first pipe 230. The air outlet pipe is used to connect the air outlet 114 of the compute node 110 with the second pipe 240. The liquid outlet pipe is used to connect the liquid outlet 225 of the liquid cooling heat dissipation device 220 with the third pipe 250.

In some possible implementations, quick connector 280 includes at least one first connector and at least one second connector mating with the first connector. The first connector is connected with the first inlet 115, the air outlet 114, the second liquid inlet 224 or the liquid outlet 225, and the second connector is used for connecting with the first pipe 230, the second pipe 240, or the third pipe 250. Alternatively, the first connector is for connection with the first pipe 230, the second pipe 240, or the third pipe 250, and the second connector is for connection with the first liquid inlet 115, the air outlet 114, the second liquid inlet 224, or the liquid outlet 225.

It is understandable that the server system 200 provided in the embodiment of the present application may be installed in the equipment room 300 of the data center. In some examples, the server system 200 provided in the embodiment of the present application may also be independently installed.

It should be noted that, unless otherwise specified and limited in the description of the present application, the terminologies "installation", "connection", and "connection" are to be understood in a broad sense, such as fixed connection or indirect connection through an intermediate medium. It may be an internal connection between two elements or an interaction between two elements. The specific meaning of the above terminologies in the present application will be understood by a person of ordinary skill in the field.

The devices or elements referred to or implied in this application must have a specific orientation. They must be constructed and operated in a specific orientation, and therefore this cannot be understood as limitation of the present application. In the description of this application, "multiple" means two or more, unless otherwise specified.

The terminologies "first", "second", "third", and "fourth", if any, in the specification and claims of the present application and the drawings are used to distinguish similar objects, and are not necessarily used to describe a particular order or sequence. It should be understood that the data used is exchangeable when appropriate, so that the embodiments of the present application described herein can be implemented, for example, in an order other than those illustrated or described herein. Furthermore, the terminologies "comprising" and "having" and any their variation are intended to cover non-exclusive inclusions. For example, processes, modes, systems, products, or equipment comprising a series of steps or units do not need to be limited to those steps or units clearly listed, but may include other steps or units that are not explicitly listed or are inherent to such processes, modes, products, or devices.

Finally, it should be noted that: The above embodiments are only used to illustrate the technical solution of the present application, and are not intended to limit the technical solution. While the present application has been described in detail with reference to the foregoing embodiments, it will be understood by a person of ordinary skill in the art: It is possible to modify the technical solutions described in the foregoing embodiments, or to replace some or all of the technical features wherein. Such modification or replacement does not leave the essence of the corresponding technical solution out of the scope of the technical solution of the embodiments of the present application.

## Claims

1. A server, comprising: a cabinet body, a first electronic node, a second electronic node, and a cooling connection device; wherein
the cabinet body comprises an accommodating cavity for accommodating the first electronic node and the second electronic node;
the cooling connection device comprises a first pipe, a second pipe, and a third pipe;
the first electronic node comprises at least one first electronic component and a housing, the housing has a cavity for accommodating the first electronic component; the housing has a first liquid inlet and an air outlet, the first liquid inlet and the air outlet are connected with the cavity, wherein the first liquid inlet is connected with the first pipe, the air outlet is connected with the second pipe, a liquid cooling medium enters the housing through the first pipe, after absorbing the heat of the first electronic component, the liquid cooling medium becomes a gaseous cooling medium, and the gaseous cooling medium flows out of the housing through the second pipe;
the second electronic node comprises at least one second electronic component and at least one liquid cooling heat dissipation device, the liquid heat dissipation device has a second liquid inlet and a liquid outlet; wherein the second liquid inlet is connected with the first pipe, and the liquid outlet is connected with the third pipe; the liquid cooling medium enters the liquid cooling heat dissipating device through the first pipe, after absorbing the heat of the second electronic component, the liquid cooling medium flows out of the liquid cooling heat dissipation device through the third pipe.

2. The server according to claim 1, wherein the first electronic node is a compute node for executing computing function, and the first electronic component includes a processor and a memory.

3. The server according to claim 2, wherein at least one sprinkler is arranged in the housing; the sprinkler is connected with the first liquid inlet, and the sprinkler is positioned above the liquid level of the liquid cooling medium; and the sprinkler is configured to spray the liquid cooling medium to the first electronic component.

4. The server according to any one of claims 1-3, wherein the second electronic node includes a switching node, to the switching node is configured to transmit network data; and the second electronic component includes a switching chip.

5. The server according to any one of claims 1-4, wherein the second electronic node comprises a power node for performing a power supply function and/or a voltage conversion function, and the second electronic component comprises a power supply.

6. The server according to any one of claims 1-5, wherein at least one second electronic node comprises a battery node, the battery node is configured to perform a standby power supply function; and the second electronic component comprises a battery.

7. The server according to any one of claims 1-6, wherein the liquid cooling heat dissipation device is a cold plate component, the cold plate component comprises at least one cold plate, the cold plate has a seal chamber for accommodating the liquid cooling medium, and the cold plate is provided with a second liquid inlet and a liquid outlet which are connected with the seal chamber.

8. The server according to claim 7, wherein the cold plate is positioned above the second electronic component.

9. The server according to any one of claims 1-8, further comprising: a quick connector;
the first liquid inlet and the air outlet of the housing are respectively connected with the first pipe and the second pipe through the quick connector;
the second liquid inlet and the liquid outlet of the liquid cooling heat dissipation device are respectively connected with the first pipe and the third pipe through the quick connector.

10. The server according to claim 9, wherein the quick connector comprises at least one first connector and at least one second connector fitting with the first connector;
the first connector is configured to connect with the first liquid inlet, the air outlet, the second liquid inlet or the liquid outlet, the second connector is configured to connect with the first pipe, the second pipe or the third pipe; or,
the first connector is configured to connect with the first pipe, the second pipe or the third pipe, and the second connector is configured to connect with the first liquid inlet, the air outlet, the second liquid inlet or the liquid outlet.

11. The server according to any one of claims 1-10, wherein the first pipe, the second pipe and the third pipe are all installed on the rear wall of the cabinet body.

12. The server according to any one of claims 1-11, wherein the inner diameter of the first pipe is greater than the inner diameter of the second pipe, and the inner diameter of the second pipe is greater than the inner diameter of the third pipe.

13. A server system includes: a cooling medium distributing device and a server according to any one of claims 1-13;
a first input end of the cooling medium distributing device is connected with the air outlet of the server through a second pipe of the server, and a second input end of the cooling medium distributing device is connected with the liquid outlet of the server through the third pipe of the server; an output end of the cooling medium distributing device is respectively connected with the first liquid inlet and the second liquid inlet of the server through the first pipe of the server;
the cooling medium distributing device is configured to convey the liquid cooling medium of the same working medium to the cavity of the server and the liquid cooling heat dissipation device;
the cooling medium distributing device is also configured to reduce the temperature of the liquid cooling medium entering the cooling medium distributing device through the third pipe;
the cooling medium distributing device is also configured to condense a gaseous cooling medium entering the cooling medium distributing device through the second pipe into a liquid cooling medium.

14. The server system of claim 13, wherein the cooling medium distributing device comprises a condenser, a liquid reservoir and a transfer pump;
an input end of the condenser is connected with the air outlet of the server through the second pipe, and an output end of the condenser is connected with a first inlet end of the liquid reservoir;
an output end of the liquid reservoir is connected with an input end of the transfer pump, a second inlet end of the liquid reservoir is connected with the liquid outlet of the server through the third pipe;
an output end of the transfer pump is respectively connected with the first liquid inlet and the second liquid inlet of the server through the first pipe.

15. The server system according to claim 13 or 14, wherein the cooling medium distributing device is installed on a side wall of the cabinet body of the server.
